# EUROPEAN PATENT APPLICATION

(11) **EP 4 693 260 A1**
(43) Date of publication of application: **11.02.2026**
(21) Application number: 24853638.5
(22) Date of filing: 07.08.2024
(51) Int. Cl.: G09F 9/30

(54) **FOLDABLE ELECTRONIC DEVICE AND HOUSING DEVICE**

(30) Priority: 11.08.2023 CN 202311015324
(71) Applicant: Huawei Technologies Co., Ltd., Shenzhen, Guangdong 518129 (CN)
(72) Inventor: HUANG, Lizhong, Shenzhen, Guangdong 518129 (CN); MAO, Jian, Shenzhen, Guangdong 518129 (CN); MAO, Weihua, Shenzhen, Guangdong 518129 (CN); LV, Ren, Shenzhen, Guangdong 518129 (CN)
(74) Representative: Gill Jennings & Every LLP
(86) International application number: PCT/CN2024/110492
(87) International publication number: WO 2025/036227

(57) **Abstract**

This application provides a foldable electronic device and a housing apparatus. A side portion that is of a first middle frame of the electronic device and that is close to a second middle frame is provided with a first mounting groove. A first groove end wall and a second groove end wall of the first mounting groove are disposed opposite to each other. A first groove side wall of the first mounting groove is connected between the first groove end wall and the second groove end wall. A first reinforcement member is fastened to the first groove end wall. A first end portion and a second end portion that are disposed opposite to each other are included in a length extension direction of a folding mechanism. A first stop block is disposed at the first end portion. When the electronic device is in a folded state, the first reinforcement member is located between the first groove side wall and the first stop block and abuts against the first stop block. Yield strength of the first reinforcement member is greater than yield strength of the first middle frame, and/or micro Vickers hardness of the first reinforcement member is greater than micro Vickers hardness of the first middle frame. The first reinforcement member can avoid a problem of local collapse of the first middle frame caused by collision between the first stop block and an adjacent part of the first middle frame.

## Description

This application claims priority to Chinese Patent Application No. 202311015324.8, filed with the China National Intellectual Property Administration on August 11, 2023, and entitled "FOLDABLE ELECTRONIC DEVICE AND HOUSING APPARATUS", which is incorporated herein by reference in its entirety.

### TECHNICAL FIELD

This application relates to the field of foldable electronic devices, and in particular, to a foldable electronic device and a housing apparatus.

### BACKGROUND

With continuous development of a flexible display screen technology, the flexible display screen technology is widely applied to a plurality of foldable electronic devices. A foldable electronic device usually includes a housing apparatus for bearing a flexible display screen. The housing apparatus usually includes two middle frames and a folding mechanism connected between two housings. The two middle frames are driven by the folding mechanism to be folded or unfolded relative to each other. In a conventional electronic device with an inward-folding screen, when the electronic device is dropped, especially when the electronic device is dropped in a folded state, a part that is of a middle frame and that is adjacent to a rotating shaft of a folding mechanism is prone to local collapse and deformation due to an impact force from the rotating shaft. Therefore, for a current electronic device with an inward-folding screen, a high-strength material is usually used to manufacture a middle frame, to improve an overall impact resistance capability and an overall deformation resistance capability of the middle frame. However, using the high-strength material to manufacture the entire middle frame greatly increases a weight of the middle frame and manufacturing costs of the middle frame. How to resolve the problem that the part that is of the middle frame and that is adjacent to the rotating shaft of the folding mechanism undergoes local collapse and deformation due to the impact force while obtaining a middle frame with a lightweight and low manufacturing costs becomes a research direction.

### SUMMARY

Implementations of this application provide a foldable electronic device and a housing apparatus, to provide a housing apparatus with a lightweight and low manufacturing costs that can resolve a problem that a part that is of a middle frame and that is adjacent to a rotating shaft of a folding mechanism undergoes local collapse and deformation due to an impact force, and an electronic device including the housing apparatus.

According to a first aspect, a foldable electronic device is provided. The electronic device includes a screen, a first middle frame, a folding mechanism, a second middle frame, and a first reinforcement member. The screen is mounted on the first middle frame and the second middle frame. The folding mechanism connects the first middle frame and the second middle frame. The first middle frame and the second middle frame are unfolded or folded relative to each other, to drive the screen to be unfolded or folded. A side portion that is of the first middle frame and that is close to the second middle frame is provided with a first mounting groove. The first mounting groove includes a first groove end wall, a second groove end wall, and a first groove side wall. The first groove end wall and the second groove end wall are disposed opposite to each other. The first groove side wall is connected between the first groove end wall and the second groove end wall. The first reinforcement member is located on a side that is of the first groove end wall and that faces the second groove end wall and is fastened to the first groove end wall. A part of the folding mechanism is located in the first mounting groove. A first end portion and a second end portion that are disposed opposite to each other are included in a length extension direction of the folding mechanism. A first stop block is disposed at the first end portion. The electronic device has an unfolded state and a folded state. When the electronic device is in the unfolded state, the first middle frame and the second middle frame are unfolded into a flat state relative to each other, the first groove side wall of the first mounting groove faces the second middle frame, and the first reinforcement member is located between the first groove side wall and the first stop block of the folding mechanism. When the electronic device is in the folded state, the first middle frame and the second middle frame are folded relative to each other, and the first reinforcement member is located between the first groove side wall and the first stop block and abuts against the first stop block. Yield strength of the first reinforcement member is greater than yield strength of the first middle frame, and/or micro Vickers hardness of the first reinforcement member is greater than micro Vickers hardness of the first middle frame.

It may be understood that in this implementation, the first middle frame of the electronic device has the first mounting groove used to mount a part of the folding mechanism, and the first reinforcement member is fastened to the first groove end wall of the first mounting groove. The yield strength of the first reinforcement member may be greater than the yield strength of the first middle frame, and/or the micro Vickers hardness of the first reinforcement member may be greater than the micro Vickers hardness of the first middle frame. In this way, when the electronic device is dropped, especially when the electronic device is dropped in the folded state, the first reinforcement member may directly bear an impact force from the first stop block of the folding mechanism. This can effectively avoid a problem of local collapse and deformation of the first middle frame caused by strong collision between the first stop block of the folding mechanism and an adjacent part of the first middle frame due to a large impact force, and this helps prolong a service life of the electronic device.

Second, upon comparison, in a conventional electronic device, a first middle frame is manufactured by using a high-strength material, to improve yield strength and/or micro Vickers hardness of the first middle frame. However, manufacturing the entire first middle frame by using the high-strength material greatly increases a weight and manufacturing costs of the first middle frame. In this implementation, only the first reinforcement member is disposed between the first groove side wall of the first mounting groove and the first stop block of the folding mechanism. In addition, the yield strength of the first reinforcement member is greater than the yield strength of the first middle frame, and/or the micro Vickers hardness of the first reinforcement member is greater than the micro Vickers hardness of the first middle frame. Therefore, there is no need to replace the entire material of the first middle frame with the high-strength material, so that an overall weight of the first middle frame is light, thereby facilitating implementation of a lightweight design of the electronic device, and the manufacturing costs of the first middle frame are low, thereby facilitating reduction of the manufacturing costs of the entire electronic device.

In a possible implementation, the first groove end wall is provided with a first assembly recess. The first reinforcement member is fastened to the first assembly recess and is at least partially located in the first assembly recess. When the electronic device is in the unfolded state, the first middle frame and the second middle frame are unfolded into the flat state relative to each other, a first recess wall of the first assembly recess faces the second middle frame, and the first reinforcement member is located between the first recess wall of the first assembly recess and the first stop block of the folding mechanism. When the electronic device is in the folded state, the first middle frame and the second middle frame are folded relative to each other, and the first reinforcement member is located between the first recess wall and the first stop block and abuts against the first stop block.

It may be understood that in this implementation, the first middle frame has the first assembly recess for assembling the first reinforcement member. The first reinforcement member is disposed in the first assembly recess, so that the first reinforcement member may be located between the first recess wall of the first assembly recess and the first stop block of the folding mechanism. The yield strength of the first reinforcement member may be greater than the yield strength of the first middle frame, and/or the micro Vickers hardness of the first reinforcement member may be greater than the micro Vickers hardness of the first middle frame. In this way, when the electronic device is dropped, especially when the electronic device is dropped in the folded state, the first reinforcement member may directly bear the impact force from the first stop block of a hinge structure. This can effectively avoid the problem of local collapse and deformation of the first middle frame caused by strong collision between the first stop block of the hinge structure and the adjacent part of the first middle frame (that is, the first recess wall of the first assembly recess in this implementation) due to the large impact force, and this helps prolong the service life of the electronic device.

In a possible implementation, the first reinforcement member includes a first surface disposed away from the first groove side wall. The first stop block includes a first stop surface. When the electronic device is in the unfolded state, the first stop surface is disposed facing the screen. When the electronic device is switched from the unfolded state to the folded state, the first middle frame is folded relative to the second middle frame until the first surface of the first reinforcement member abuts against the first stop surface of the first stop block. In this way, the first stop surface of the first stop block may cooperate with the first surface of the first reinforcement member when the electronic device is folded, to avoid damage to the screen caused by excessive folding of the first middle frame and the second middle frame.

In a possible implementation, when the electronic device is in the unfolded state, a direction from the first middle frame to the second middle frame is a first direction. In the first direction, a distance between the first reinforcement member and the first stop block of the folding mechanism is less than or equal to three millimeters. In this way, the first reinforcement member may be disposed adjacent to the first stop block of the folding mechanism, and the first reinforcement member has better impact resistance effect. This helps prolong the service life of the electronic device.

In a possible implementation, the first assembly recess further includes a second recess wall. The second recess wall faces the first mounting groove. The electronic device further includes a fastener. The fastener fastens the first reinforcement member to the second recess wall. In this way, the first reinforcement member is fastened to the second recess wall by using the fastener. This helps improve stability of a connection between the first reinforcement member and the second recess wall.

In a possible implementation, the first reinforcement member is provided with a mounting hole. The second recess wall is provided with a mounting recess. The mounting hole communicates with the mounting recess. A part of the fastener is located in the mounting hole, and the other part of the fastener is located in the mounting recess.

It may be understood that a housing apparatus in this implementation may further include the fastener. The first reinforcement member may further be provided with the mounting hole. The second recess wall of the first assembly recess may further be provided with the mounting recess. The fastener may sequentially penetrate the mounting hole of the first reinforcement member and the mounting recess of the second recess wall to fasten the first reinforcement member to the first assembly recess. In this way, a part of the fastener may be embedded in the first reinforcement member, and the other part of the fastener may be embedded in the first middle frame, so that reliability of a connection between the first reinforcement member and the first middle frame is improved. In addition, the part of the fastener is embedded in the first middle frame, so that when the first reinforcement member bears an impact force from the folding mechanism, a part of impact load may be further transferred to the first middle frame through the fastener, and in this way, the first middle frame may further share the part of the impact load. This helps improve an impact resistance capability of the first reinforcement member.

In a possible implementation, a first included angle is formed between a center line of the mounting hole and a bottom wall of the first mounting groove. The first included angle is less than 90°. An opening of the mounting hole faces the screen. In this way, the mounting hole may be disposed in an oblique manner relative to the bottom wall that is of the first mounting groove and that faces the screen. Therefore, the fastener can be mounted in the mounting hole and the mounting recess, so that fastening of the first reinforcement member is more convenient, and assembly efficiency is improved.

In a possible implementation, a limiting protrusion is disposed on the first reinforcement member. The limiting protrusion and the mounting hole are spaced apart. The second recess wall is further provided with a matching recess. The matching recess and the mounting recess are spaced apart. The limiting protrusion is embedded in the matching recess. In this way, the limiting protrusion may cooperate with the fastener, to enhance stability of a connection between the first reinforcement member and the first assembly recess. In addition, when the first reinforcement member is subject to the impact force from the first stop block of the folding mechanism, the limiting protrusion may also share a part of the impact load, so that the first reinforcement member can bear a larger impact force. This helps improve the impact resistance capability of the first reinforcement member.

In a possible implementation, a second included angle is formed between a center line of the limiting protrusion and the first direction. The second included angle is less than 90°. An opening of the second included angle faces the first recess wall. The first direction is the direction from the first middle frame to the second middle frame when the electronic device is in the unfolded state.

It may be understood that in this implementation, the limiting protrusion is disposed on a surface (that is, a second surface of the first reinforcement member in this implementation) that is of the first reinforcement member and that faces the first assembly recess. The second included angle that is less than 90° may be formed between a length extension direction of the limiting protrusion and the first direction, and the opening of the second included angle may face the first recess wall of the first assembly recess, that is, the opening of the second included angle β may face a third surface of the first reinforcement member. In this way, when the first reinforcement member is subject to the impact force from the first stop block of the folding mechanism, the limiting protrusion may also share a part of the impact load, so that the first reinforcement member can bear a larger impact force. This helps improve the impact resistance capability of the first reinforcement member.

In a possible implementation, the first assembly recess further includes a second recess wall. The second recess wall faces the first mounting groove. A connection protrusion is disposed on a surface that is of the first reinforcement member and that faces the second recess wall. The second recess wall is provided with a mounting recess. The connection protrusion is embedded in the mounting recess to fasten the first reinforcement member to the second recess wall.

It may be understood that in this implementation, the connection protrusion is formed on a surface (that is, the second surface of the first reinforcement member in this implementation) that is of the first reinforcement member and that faces the second recess wall of the first assembly recess, and the first reinforcement member is fastened to the second recess wall through cooperation between the connection protrusion and the mounting recess, to replace a fastening solution in which an additional fastener (for example, a screw) is disposed to fasten the first reinforcement member to the second recess wall, so that no additional fastener needs to be disposed on the housing apparatus. This helps reduce overall manufacturing costs of the electronic device. Second, the connection protrusion in this implementation is directly formed on the surface of the first reinforcement member, the connection protrusion and the first reinforcement member may be integrally processed, and a manufacturing process is simpler. In addition, volumes of the connection protrusion and the first reinforcement member may be smaller, so that the connection protrusion and the first reinforcement member can be better adapted to an electronic device in which a first middle frame has a thin wall, and the connection protrusion and the first reinforcement member are more widely used.

In a possible implementation, the folding mechanism includes a first connection structure, a second connection structure, and a hinge structure. The hinge structure connects the first connection structure and the second connection structure. At least a part of the first connection structure is located in the first mounting groove and is connected to the first middle frame. A side portion that is of the second middle frame and that is close to the first middle frame is provided with a second mounting groove. At least a part of the second connection structure is located in the second mounting groove and is connected to the second middle frame. In a length extension direction of the folding mechanism, the hinge structure includes a first end and a second end that are disposed opposite to each other. The first stop block is located on a side that is of the first end and that is away from the second end and is fastened to the first end. In this way, the first stop block may be located at an end portion of the hinge structure, so that a stop function can be implemented without affecting relative motion between the hinge structure and another component.

In a possible implementation, when the electronic device is in the unfolded state, the direction from the first middle frame to the second middle frame is the first direction. In the first direction, a width of the first stop block is less than a width of the hinge structure. In this way, when the electronic device is in the folded state, the first stop block can implement the stop function without increasing a thickness of the electronic device in the folded state, and user experience is better.

In a possible implementation, a difference between the yield strength of the first reinforcement member and the yield strength of the first middle frame is greater than 50 MP, and/or a difference between the micro Vickers hardness of the first reinforcement member and the micro Vickers hardness of the first middle frame is greater than 30 HV. In this way, the first reinforcement member has a better impact resistance capability. This helps prolong the service life of the electronic device.

In a possible implementation, the yield strength of the first reinforcement member is less than or equal to yield strength of the first stop block of the folding mechanism, and/or the micro Vickers hardness of the first reinforcement member is less than or equal to micro Vickers hardness of the first stop block of the folding mechanism.

It may be understood that in this implementation, the yield strength of the first reinforcement member may further be less than the yield strength of the first stop block of the folding mechanism, and/or the micro Vickers hardness of the first reinforcement member may alternatively be less than the micro Vickers hardness of the first stop block. In this way, when the first reinforcement member collides with the first stop block, the first stop block is not easily damaged by the first reinforcement member. This helps prolong a service life of the first stop block.

Alternatively, the yield strength of the first reinforcement member may be equal to the yield strength of the first stop block of the folding mechanism, and/or the micro Vickers hardness of the first reinforcement member may be equal to the micro Vickers hardness of the first stop block. In this way, the yield strength of the first reinforcement member is high, so that the first reinforcement member can better bear the impact force from the first stop block of the folding mechanism, and the first reinforcement member has a better impact resistance capability. In addition, the yield strength of the first reinforcement member is equal to the yield strength of the first stop block of the folding mechanism, so that the first reinforcement member is not easily deformed even if the first reinforcement member is impacted by the first stop block of the folding mechanism. This helps prolong a service life of the first reinforcement member. In addition, a case in which after the first stop block of the folding mechanism collides with the first reinforcement member, the first stop block undergoes local collapse and deformation because the yield strength of the first reinforcement member is greater than the yield strength of the first stop block of the folding mechanism, and/or the micro Vickers hardness of the reinforcement member is greater than the micro Vickers hardness of the first stop block does not occur. This helps prolong a service life of the folding mechanism, thereby helping prolong the service life of the entire electronic device.

In a possible implementation, a material of the first reinforcement member is a titanium alloy material, an iron-based material, an aluminum-based material, a copper-based material, or a nickel-based material. In this way, the first reinforcement member has a strong impact resistance capability and can meet a drop reliability requirement of the electronic device.

In a possible implementation, the first middle frame includes a main plate, a first extension plate, a second extension plate, and a third extension plate. The first extension plate and the second extension plate are connected to a same side of the main plate and are respectively located at two ends of the main plate. The third extension plate is connected between the first extension plate and the second extension plate. The third extension plate is further connected to the main plate, and there is a height difference between the third extension plate and the main plate in a thickness direction of the first middle frame. The main plate, the first extension plate, the second extension plate, and the third extension plate enclose the first mounting groove. A surface that is of the first extension plate and that faces the second extension plate forms the first groove end wall, and a surface that is of the main plate and that faces the first extension plate forms the first groove side wall. In this way, the first middle frame may have the first mounting groove used to mount the part of the folding mechanism, so that the folding mechanism can use thickness space of the first middle frame. This helps implement thin setting of the electronic device.

According to a second aspect, a housing apparatus is provided. The housing apparatus includes a first middle frame, a folding mechanism, a second middle frame, and a first reinforcement member. The folding mechanism connects the first middle frame and the second middle frame. The first middle frame and the second middle frame are unfolded or folded relative to each other, so that the housing apparatus is unfolded or folded. A side portion that is of the first middle frame and that is close to the second middle frame is provided with a first mounting groove. The first mounting groove includes a first groove end wall, a second groove end wall, and a first groove side wall. The first groove end wall and the second groove end wall are disposed opposite to each other. The first groove side wall is connected between the first groove end wall and the second groove end wall. The first reinforcement member is located on a side that is of the first groove end wall and that faces the second groove end wall and is fastened to the first groove end wall. A part of the folding mechanism is located in the first mounting groove. A first end portion and a second end portion that are disposed opposite to each other are included in a length extension direction of the folding mechanism. A first stop block is disposed at the first end portion. The housing apparatus includes an unfolded state and a folded state. When the housing apparatus is in the unfolded state, the first middle frame and the second middle frame are unfolded into a flat state relative to each other, the first groove side wall of the first mounting groove faces the second middle frame, and the first reinforcement member is located between the first groove side wall and the first stop block of the folding mechanism. When the housing apparatus is in the folded state, the first middle frame and the second middle frame are folded relative to each other, and the first reinforcement member is located between the first groove side wall and the first stop block and abuts against the first stop block. Yield strength of the first reinforcement member is greater than yield strength of the first middle frame, and/or micro Vickers hardness of the first reinforcement member is greater than micro Vickers hardness of the first middle frame.

It may be understood that in this implementation, the first middle frame of the housing apparatus has the first mounting groove used to mount a part of the folding mechanism, and the first reinforcement member is fastened to the first groove end wall of the first mounting groove. The yield strength of the first reinforcement member may be greater than the yield strength of the first middle frame, and/or the micro Vickers hardness of the first reinforcement member may be greater than the micro Vickers hardness of the first middle frame. In this way, when the housing apparatus is dropped, especially when the housing apparatus is dropped in the folded state, the first reinforcement member may directly bear an impact force from the first stop block of the folding mechanism. This can effectively avoid a problem of local collapse and deformation of the first middle frame caused by strong collision between the first stop block of the folding mechanism and an adjacent part of the first middle frame due to a large impact force, and this helps prolong a service life of the housing apparatus.

Second, upon comparison, in a conventional housing apparatus, a first middle frame is manufactured by using a high-strength material, to improve yield strength and/or micro Vickers hardness of the first middle frame. However, manufacturing the entire first middle frame by using the high-strength material greatly increases a weight and manufacturing costs of the first middle frame. In this implementation, only the first reinforcement member is disposed between the first groove side wall of the first mounting groove and the first stop block of the folding mechanism. In addition, the yield strength of the first reinforcement member is greater than the yield strength of the first middle frame, and/or the micro Vickers hardness of the first reinforcement member is greater than the micro Vickers hardness of the first middle frame. Therefore, there is no need to replace the entire material of the first middle frame with the high-strength material, so that an overall weight of the first middle frame is light, thereby facilitating implementation of a lightweight design of the housing apparatus, and the manufacturing costs of the first middle frame are low, thereby facilitating reduction of the manufacturing costs of the entire housing apparatus.

In a possible implementation, the first groove end wall is provided with a first assembly recess. The first reinforcement member is fastened to the first assembly recess and is at least partially located in the first assembly recess. When the housing apparatus is in the unfolded state, the first middle frame and the second middle frame are unfolded into the flat state relative to each other, and a first recess wall of the first assembly recess faces the second middle frame. The first reinforcement member is located between the first recess wall of the first assembly recess and the first stop block of the folding mechanism. When the housing apparatus is in the folded state, the first middle frame and the second middle frame are folded relative to each other, and the first reinforcement member is located between the first recess wall and the first stop block and abuts against the first stop block.

It may be understood that in this implementation, the first middle frame has the first assembly recess for assembling the first reinforcement member. The first reinforcement member is disposed in the first assembly recess, so that the first reinforcement member may be located between the first recess wall of the first assembly recess and the first stop block of the folding mechanism. The yield strength of the first reinforcement member may be greater than the yield strength of the first middle frame, and/or the micro Vickers hardness of the first reinforcement member may be greater than the micro Vickers hardness of the first middle frame. In this way, when the housing apparatus is dropped, especially when the housing apparatus is dropped in the folded state, the first reinforcement member may directly bear the impact force from the first stop block of a hinge structure. This can effectively avoid the problem of local collapse and deformation of the first middle frame caused by strong collision between the first stop block of the hinge structure and the adjacent part of the first middle frame (that is, the first recess wall of the first assembly recess in this implementation) due to the large impact force, and this helps prolong the service life of the housing apparatus.

In a possible implementation, a side that is of the housing apparatus and that is used to mount a screen is a mounting side of the housing apparatus. The first reinforcement member includes a first surface disposed away from the first recess wall. The first stop block includes a first stop surface. When the housing apparatus is in the unfolded state, the first stop surface is disposed facing the mounting side. When the housing apparatus is switched from the unfolded state to the folded state, the first middle frame is folded relative to the second middle frame until the first surface of the first reinforcement member abuts against the first stop surface of the first stop block. In this way, the first stop surface of the first stop block may cooperate with the first surface of the first reinforcement member when the housing apparatus is folded, to avoid excessive folding of the first middle frame and the second middle frame.

In a possible implementation, when the housing apparatus is in the unfolded state, a direction from the first middle frame to the second middle frame is a first direction. In the first direction, a distance between the first reinforcement member and the first stop block of the folding mechanism is less than or equal to three millimeters. In this way, the first reinforcement member may be disposed adjacent to the first stop block of the folding mechanism, and the first reinforcement member has better impact resistance effect. This helps prolong the service life of the housing apparatus.

In a possible implementation, the first assembly recess further includes a second recess wall. The second recess wall faces the first mounting groove. The housing apparatus further includes a fastener. The fastener fastens the first reinforcement member to the second recess wall. In this way, the first reinforcement member is fastened to the second recess wall by using the fastener. This helps improve stability of a connection between the first reinforcement member and the second recess wall.

In a possible implementation, the first reinforcement member is provided with a mounting hole. The second recess wall is provided with a mounting recess. The mounting hole communicates with the mounting recess. A part of the fastener is located in the mounting hole. The other part of the fastener is located in the mounting recess.

It may be understood that the housing apparatus in this implementation may further include the fastener. The first reinforcement member may further be provided with the mounting hole. The second recess wall of the first assembly recess may further be provided with the mounting recess. The fastener may sequentially penetrate the mounting hole of the first reinforcement member and the mounting recess of the second recess wall to fasten the first reinforcement member to the first assembly recess. In this way, a part of the fastener may be embedded in the first reinforcement member, and the other part of the fastener may be embedded in the first middle frame, so that reliability of a connection between the first reinforcement member and the first middle frame is improved. In addition, the part of the fastener is embedded in the first middle frame, so that when the first reinforcement member bears an impact force from the folding mechanism, a part of impact load may be further transferred to the first middle frame through the fastener, and in this way, the first middle frame may further share the part of the impact load. This helps improve an impact resistance capability of the first reinforcement member.

In a possible implementation, a first included angle is formed between a center line of the mounting hole and a bottom wall of the first mounting groove. Tthe first included angle is less than 90°. An opening of the mounting hole faces the mounting side. In this way, the mounting hole may be disposed in an oblique manner relative to the bottom wall that is of the first mounting groove and that faces the screen. Therefore, the fastener can be mounted in the mounting hole and the mounting recess, so that fastening of the first reinforcement member is more convenient, and assembly efficiency is improved.

In a possible implementation, a difference between the yield strength of the first reinforcement member and the yield strength of the first middle frame is greater than 50 MP, and/or a difference between the micro Vickers hardness of the first reinforcement member and the micro Vickers hardness of the first middle frame is greater than 30 HV. In this way, the first reinforcement member has a better impact resistance capability. This helps prolong the service life of the housing apparatus.

In a possible implementation, the yield strength of the first reinforcement member is less than or equal to yield strength of the first stop block of the folding mechanism, and/or the micro Vickers hardness of the first reinforcement member is less than or equal to micro Vickers hardness of the first stop block of the folding mechanism. It may be understood that in this implementation, the yield strength of the first reinforcement member may further be less than the yield strength of the first stop block of the folding mechanism, and/or the micro Vickers hardness of the first reinforcement member may alternatively be less than the micro Vickers hardness of the first stop block. In this way, when the first reinforcement member collides with the first stop block, the first stop block is not easily damaged by the first reinforcement member. This helps prolong a service life of the first stop block.

Alternatively, the yield strength of the first reinforcement member may be equal to the yield strength of the first stop block of the folding mechanism, and/or the micro Vickers hardness of the first reinforcement member may be equal to the micro Vickers hardness of the first stop block. In this way, the yield strength of the first reinforcement member is high, so that the first reinforcement member can better bear the impact force from the first stop block of the folding mechanism, and the first reinforcement member has a better impact resistance capability. In addition, the yield strength of the first reinforcement member is equal to the yield strength of the first stop block of the folding mechanism, so that the first reinforcement member is not easily deformed even if the first reinforcement member is impacted by the first stop block of the folding mechanism. This helps prolong a service life of the first reinforcement member. In addition, a case in which after the first stop block of the folding mechanism collides with the first reinforcement member, the first stop block undergoes local collapse and deformation because the yield strength of the first reinforcement member is greater than the yield strength of the first stop block of the folding mechanism, and/or the micro Vickers hardness of the reinforcement member is greater than the micro Vickers hardness of the first stop block does not occur. This helps prolong a service life of the folding mechanism, thereby helping prolong the service life of the entire housing apparatus.

In a possible implementation, a material of the first reinforcement member is a titanium alloy material, an iron-based material, an aluminum-based material, a copper-based material, or a nickel-based material. In this way, the first reinforcement member has a strong impact resistance capability and can meet a drop reliability requirement of the housing apparatus.

### BRIEF DESCRIPTION OF DRAWINGS

To describe the technical solutions in implementations of this application or in the background more clearly, the following describes the accompanying drawings for describing implementations of this application or the background.
FIG. 1a is a diagram of a structure of an electronic device in an unfolded state according to an implementation of this application;
FIG. 1b is a diagram of a structure of the electronic device shown in FIG. 1a in a folded state;
FIG. 2 is an exploded view of a structure of the electronic device shown in FIG. 1a according to some implementations;
FIG. 3 is a diagram of a part of a structure of a housing apparatus of the electronic device shown in FIG. 1a according to an implementation;
FIG. 4 is an exploded view of a structure of the housing apparatus shown in FIG. 3 according to an implementation;
FIG. 5 is a diagram of a structure of a first middle frame of the housing apparatus shown in FIG. 4;
FIG. 6 is a diagram of a structure of a reinforcement member of the housing apparatus shown in FIG. 3 at different angles of view according to an implementation;
FIG. 7a is a diagram of a part of an assembly structure of a first reinforcement member, a fastener, and a first middle frame of the housing apparatus shown in FIG. 3;
FIG. 7b is a diagram of a structure of a part of a cross section according to an implementation in which the electronic device shown in FIG. 1a is cut along A-A;
FIG. 8 is a diagram of a structure of a folding mechanism of the housing apparatus shown in FIG. 3;
FIG. 9 is a diagram of a structure of a part of a cross section according to an implementation in which the electronic device shown in FIG. 1a is cut along B-B;
FIG. 10a is a diagram of an assembly structure of a first middle frame and a folding mechanism shown in FIG. 4;
FIG. 10b is a diagram of a part of an assembly structure of a first middle frame, a second middle frame, and a folding mechanism shown in FIG. 4;
FIG. 11 is a diagram of a structure of a part of a cross section according to an implementation in which the electronic device shown in FIG. 1b is cut along C-C;
FIG. 12 is a diagram of a structure of a part of a cross section according to an implementation in which the electronic device shown in FIG. 1b is cut along D-D;
FIG. 13 is a diagram of a structure of a part of a cross section according to an implementation in which the electronic device shown in FIG. 1b is cut along D-D;
FIG. 14 is a diagram of a structure of a part of a cross section according to an implementation in which the electronic device shown in FIG. 1a is cut along A-A;
FIG. 15 is a diagram of a structure of a part of a cross section according to an implementation in which the electronic device shown in FIG. 1a is cut along E-E;
FIG. 16 is a diagram of a structure of the reinforcement member shown in FIG. 6 at different angles of view according to another implementation;
FIG. 17 is a diagram of the structure shown in FIG. 7b at a different angle of view according to another implementation;
FIG. 18 is a diagram of a structure of the reinforcement member shown in FIG. 6 according to still another implementation;
FIG. 19 is a diagram of the structure shown in FIG. 7b at another angle of view according to still another implementation; and
FIG. 20 is a diagram of a part of the structure shown in FIG. 10a according to another implementation.

### DESCRIPTION OF EMBODIMENTS

The following describes implementations of this application with reference to the accompanying drawings in implementations of this application.

In descriptions of implementations of this application, it should be noted that the terms "mounting" and "connection" should be understood in a broad sense, unless otherwise specified and limited. For example, "connection" may be a detachable connection or a non-detachable connection, or may be a direct connection or a connection through an intermediate medium. "Fastening" means a connection to each other and a relative position relationship unchanged after the connection. Orientation terms mentioned in implementations of this application, for example, "above", "below", "inner", and "outer", merely indicate directions with reference to accompanying drawings. Therefore, the orientation terms are used to better and more clearly describe and understand implementations of this application, but do not indicate or imply that a specified apparatus or element needs to have a specific orientation or be constructed or operated in a specific orientation. Therefore, this cannot be understood as a limitation on implementations of this application. "A plurality of" means at least two.

In implementations of this application, the terms "first", "second", "third", and "fourth" are merely intended for a purpose of description, and shall not be understood as an indication or implication of relative importance or an implicit indication of a quantity of indicated technical features. Therefore, a feature limited by "first", "second", "third", or "fourth" may explicitly or implicitly include one or more of the features.

In implementations of this application, "and/or" describes only an association relationship between associated objects and indicates that three relationships may exist. For example, A and/or B may indicate the following three cases: Only A exists, both A and B exist, and only B exists. In addition, the character "/" in this specification generally indicates an "or" relationship between the associated objects.

Reference to "an implementation", "some implementations", or the like described in this specification means that one or more implementations of this application include a specific feature, structure, or characteristic described with reference to the implementation. Therefore, statements such as "in an implementation", "in some implementations", "in some other implementations", and "in another implementation" that appear at different places in this specification do not necessarily mean reference to a same implementation. Instead, the statements mean "one or more but not all of implementations", unless otherwise specifically emphasized in another manner. The terms "include", "contain", "have", and their variants all mean "include but are not limited to", unless otherwise specifically emphasized in another manner.

It can be understood that specific implementations described herein are merely intended to explain a related invention, but not to limit the invention. In addition, it should be further noted that, for ease of description, only a part related to the invention is shown in the accompanying drawings.

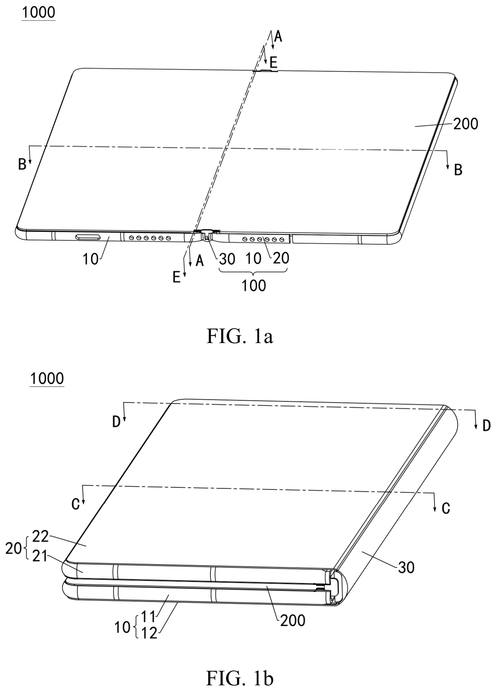

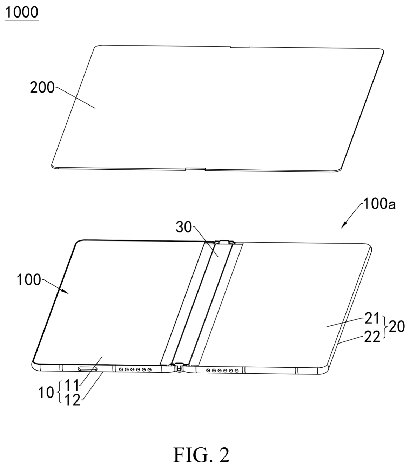

FIG. 1a is a diagram of a structure of an electronic device 1000 in an unfolded state according to an implementation of this application. FIG. 1b is a diagram of a structure of the electronic device 1000 shown in FIG. 1a in a folded state. FIG. 2 is an exploded view of a structure of the electronic device 1000 shown in FIG. 1a in some implementations.

As shown in FIG. 1a to FIG. 2, the electronic device 1000 may include a housing apparatus 100 and a screen 200. The screen 200 may be mounted on a mounting side 100a of the housing apparatus 100. The housing apparatus 100 may be in the unfolded state shown in FIG. 1a and the folded state shown in FIG. 1b. The housing apparatus 100 may alternatively be in an intermediate state between the unfolded state and the folded state. The intermediate state may be any state between the unfolded state and the folded state. The screen 200 may move along with the housing apparatus 100. The housing apparatus 100 may drive the screen 200 to be unfolded or folded, so that the electronic device 1000 can be unfolded to the unfolded state or folded to the folded state. When the electronic device 1000 is in the folded state, the screen 200 may be located on an inner side of the housing apparatus 100. In other words, the electronic device 1000 may be an electronic device with an inward-folding screen. It should be understood that FIG. 1a and FIG. 1b show only some components included in the electronic device 1000 as an example. Actual shapes, actual sizes, and actual structures of these components are not limited by FIG. 1a and FIG. 1b. In another implementation, when the electronic device 1000 is a device in another form, the electronic device 1000 may not include the screen 200.

In this implementation, when the electronic device 1000 is in the unfolded state, the screen 200 may be unfolded into a flat state. In this case, the screen 200 can perform full-screen display, and the electronic device 1000 has a large display area. This helps improve viewing experience and operation experience of a user. When the electronic device 1000 is in the folded state, a planar size of the electronic device 1000 is small, so that it is convenient for the user to carry and place the electronic device 1000.

For example, the housing apparatus 100 may include a first housing 10, a second housing 20, and a folding mechanism 30. The folding mechanism 30 may connect the first housing 10 and the second housing 20. The folding mechanism 30 may move, so that the first housing 10 and the second housing 20 can be unfolded relative to each other to the unfolded state, or folded relative to each other to the folded state. The screen 200 may be fastened to the first housing 10 and the second housing 20. The first housing 10 may include a first middle frame 11 and a first rear cover 12. The first rear cover 12 may be located on a side that is of the first middle frame 11 and that faces away from the screen 200 and is fastened to the first middle frame 11. The second housing 20 may include a second middle frame 21 and a second rear cover 22. The second rear cover 22 may be located on a side that is of the second middle frame 21 and that faces away from the screen 200 and is fastened to the second middle frame 21. In this case, a surface that is of the first rear cover 12 and that faces away from the first middle frame 11 may form an appearance surface of the first housing 10. A surface that is of the second rear cover 22 and that faces away from the second middle frame 21 may form an outer surface of the second housing 20. It should be understood that both the first housing 10 and the second housing 20 are housing components, are configured to mount and fasten other components of the electronic device, and have diversified structures. The folding mechanism 30 is configured to implement relative motion between the first housing 10 and the second housing 20, and also has diversified structures. Specific structures of the first housing 10, the second housing 20, and the folding mechanism 30 are not strictly limited in this implementation of this application. The accompanying drawings of this application show only general structures of the first housing 10, the second housing 20, and the folding mechanism 30 in an implementation.

For example, a display function and a touch sensing function may be integrated into the screen 200. The display function of the screen 200 is used to display an image, a video, and the like, and the touch sensing function of the screen 200 is used to sense a touch action of the user to implement human-machine interaction. For example, the screen 200 includes a bendable flexible display screen. The flexible display screen may be a liquid crystal display (liquid crystal display, LCD) screen, an organic light-emitting diode (organic light-emitting diode, OLED) display screen, an active-matrix organic light-emitting diode (active-matrix organic light-emitting diode, AMOLED) display screen, a flexible light-emitting diode (flexible light-emitting diode, FLED) display screen, a mini-LED display screen, a micro-LED display screen, a micro-OLED display screen, a quantum dot light-emitting diode (quantum dot light-emitting diode, QLED) display screen, or the like. For ease of understanding, a direction that is the same as a light-emitting direction of the screen 200 is defined as "up", and a direction that is opposite to the light-emitting direction of the screen 200 is defined as "down".

For example, the electronic device 1000 may further include a plurality of components (not shown in the figure), and the plurality of components are mounted inside the housing apparatus 100. The plurality of components may include, for example, a processor, an internal memory, an interface for external memory, a universal serial bus (universal serial bus, USB) interface, a charging management module, a power management module, a battery, an antenna, a communication module, a camera, an audio module, a speaker, a receiver, a microphone, a headset jack, a sensor module, a button, a motor, an indicator, a subscriber identity module (subscriber identity module, SIM) card interface, and the like.

In this implementation, an example in which the electronic device 1000 has a two-fold structure is used for description. That is, the electronic device 1000 includes two planar parts and a bending part connected between the two planar parts. The two planar parts may rotate toward to each other to be stacked (corresponding to the foregoing folded state), so that the electronic device 1000 presents a form of two layers. Alternatively, the two planar parts may rotate opposite to each other to be unfolded into a flat state (corresponding to the foregoing unfolded state). In some other implementations, the electronic device 1000 may alternatively have a structure of more than three folds, or the like. That is, the electronic device 1000 includes more than three planar parts, two adjacent planar parts are connected through a bending part, and the two adjacent planar parts may rotate toward each other to be stacked or rotate away from each other to be unfolded into the flat state. When the electronic device 1000 has the structure of more than three folds, for a structure of the electronic device 1000, refer to the description of the two-fold structure in this embodiment for adaptive design. Details are not described in this application again.

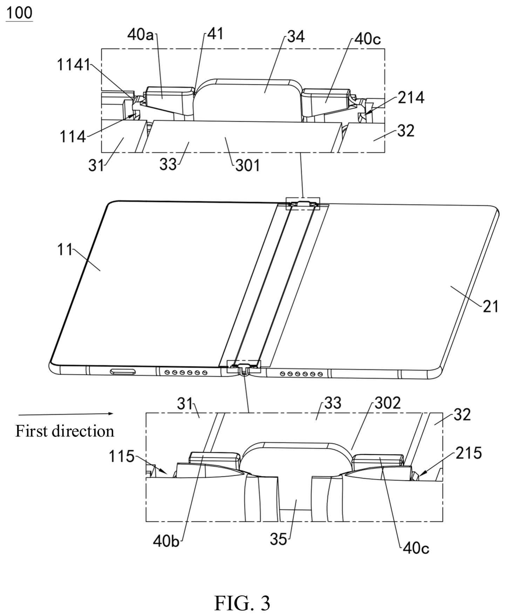

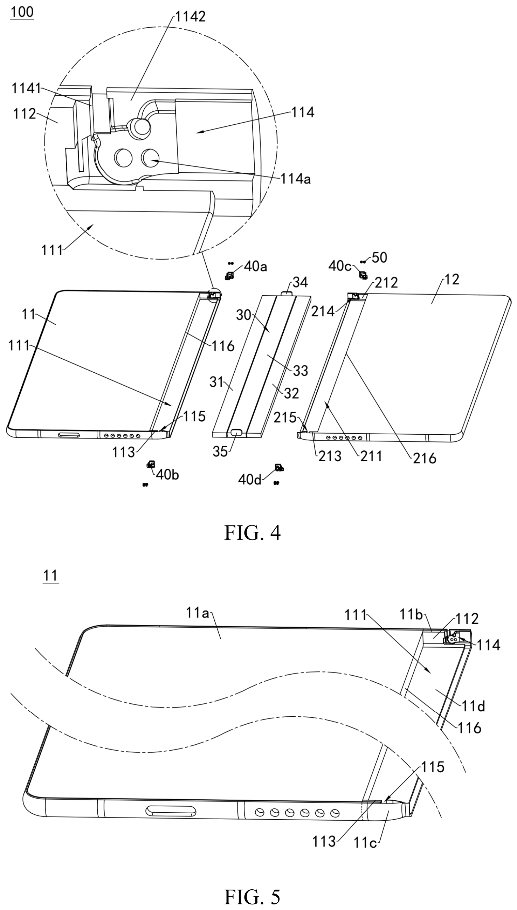

FIG. 3 is a diagram of a part of a structure of a housing apparatus 100 of the electronic device 1000 shown in FIG. 1a according to an implementation. FIG. 4 is an exploded view of a structure of the housing apparatus 100 shown in FIG. 3 according to an implementation. FIG. 5 is a diagram of a structure of the first middle frame 11 of the housing apparatus 100 shown in FIG. 4.

As shown in FIG. 3 to FIG. 5, the first middle frame 11 may include a main plate 11a, a first extension plate 11b, a second extension plate 11c, and a third extension plate 11d. The first extension plate 11b and the second extension plate 11c may be connected to a same side of the main plate 11a and are respectively located at two ends of the main plate 11a. The third extension plate 11d may be connected between the first extension plate 11b and the second extension plate 11c. The third extension plate 11d may further be connected to the main plate 11a. There is a height difference between the third extension plate 11d and the main plate 11a in a thickness direction of the electronic device 1000. In this case, the main plate 11a, the first extension plate 11b, the second extension plate 11c, and the third extension plate 11d may jointly enclose a first mounting groove 111. When the electronic device 1000 is in an unfolded state, the first extension plate 11b, the second extension plate 11c, and the third extension plate 11d may all be located on a side that is of the main plate 11a and that is close to the second middle frame 21. It should be understood that, although the first middle frame 11 is divided into four parts for description in this implementation, the first middle frame 11 may be of an integrated structure, that is, the main plate 11a, the first extension plate 11b, the second extension plate 11c, and the third extension plate 11d may be integrated.

For example, the first mounting groove 111 may include a first groove end wall 112, a second groove end wall 113, and a first groove side wall 116. The first groove end wall 112 may be formed on a surface that is of the first extension plate 11b and that faces the second extension plate 11c. The second groove end wall 113 may be formed on a surface that is of the second extension plate 11c and that faces the first extension plate 11b. The first groove side wall 116 may be formed on a surface that is of the main plate 11a and that faces the first extension plate 11b. In this case, the first groove end wall 112 may be disposed opposite to the second groove end wall 113. The first groove side wall 116 may be connected between the first groove end wall 112 and the second groove end wall 113.

For example, at least a part of a surface that is of the first groove end wall 112 and that faces the second groove end wall 113 may be recessed inward to form a first assembly recess 114. The first assembly recess 114 may communicate with the first mounting groove 111. The first assembly recess 114 may include a first recess wall 1141 and a second recess wall 1142. When the electronic device 1000 is in the unfolded state, the first recess wall 1141 may face the second middle frame 21. The second recess wall 1142 may face the second groove end wall 113 of the first mounting groove 111. The second recess wall 1142 may be provided with a mounting recess 114a. An opening of the mounting recess 114a may face the second groove end wall 113. For example, at least a part of a surface that is of the second groove end wall 113 and that faces the first groove end wall 112 may be recessed inward to form a second assembly recess 115. A structure of the second assembly recess 115 is approximately the same as a structure of the first assembly recess 114, and details are not described herein again.

It should be understood that the first recess wall 1141 may not be a complete wall surface. For example, the first recess wall 1141 may form a plurality of wall surfaces that face away from the main plate 11a due to some structural protrusions or recesses. In this way, the plurality of wall surfaces that face away from the main plate 11a may jointly form the first recess wall 1141. In other words, wall surfaces that are in the first assembly recess 114 and that face away from the main plate 11a (that is, that face the second middle frame 21 when the electronic device 1000 is in the unfolded state) may all form a part of the first recess wall 1141.

For example, the second middle frame 21 may be provided with a second mounting groove 211. The second mounting groove 211 may include a first groove end wall 212 and a second groove end wall 213 that are disposed opposite to each other. The second mounting groove 211 may further include a first groove side wall 216 connected between the first groove end wall 212 and the second groove end wall 213. At least a part of a surface that is of the first groove end wall 212 of the second mounting groove 211 and that faces the second groove end wall 213 may be recessed inward to form a third assembly recess 214. At least a part of a surface that is of the second groove end wall 213 of the second mounting groove 211 and that faces the first groove end wall 212 may be recessed inward to form a fourth assembly recess 215. Both the third assembly recess 214 and the fourth assembly recess 215 may communicate with the second mounting groove 211. Structures of the third assembly recess 214 and the fourth assembly recess 215 are approximately the same as the structure of the first assembly recess 114, and details are not described herein again.

For example, materials of both the first middle frame 11 and the second middle frame 21 may be aluminum alloy.

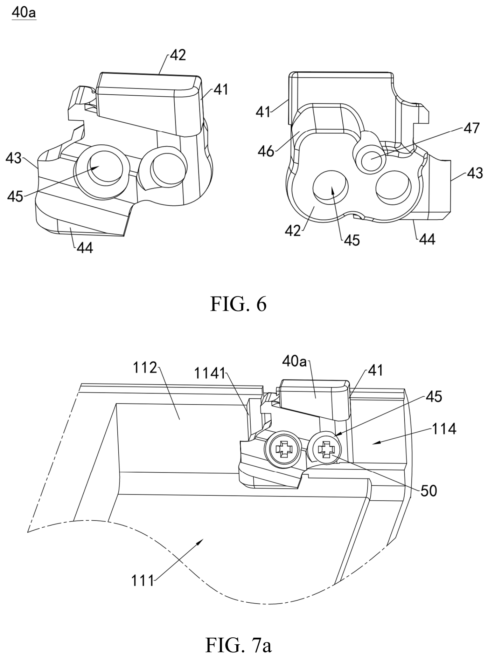

FIG. 6 is a diagram of a structure of a first reinforcement member 40a of the housing apparatus 100 shown in FIG. 3 at different angles of view according to an implementation.

As shown in FIG. 6, the housing apparatus 100 may further include at least one reinforcement member. The reinforcement member may be roughly in a block shape. The reinforcement member may be manufactured in a manner of 3D printing molding, metal injection molding, or the like. A material of the reinforcement member may be a high-strength material, such as a titanium alloy material, an iron-based material, an aluminum-based material, a copper-based material, or a nickel-based material. Yield strength of the reinforcement member may be greater than yield strength of the first middle frame 11. Micro Vickers hardness of the reinforcement member may be greater than micro Vickers hardness of the first middle frame 11. For example, a difference between the yield strength of the reinforcement member and the yield strength of the first middle frame 11 may be greater than 50 MPa, and/or a difference between the micro Vickers hardness of the reinforcement member and the micro Vickers hardness of the first middle frame 11 may be greater than 30 HV.

In this implementation, there may be four reinforcement members, and the four reinforcement members may all have a same shape and size. For example, the first reinforcement member 40a, a second reinforcement member 40b, a third reinforcement member 40c, and a fourth reinforcement member 40d are included. The first reinforcement member 40a, the second reinforcement member 40b, the third reinforcement member 40c, and the fourth reinforcement member 40d may be fastened to the first assembly recess 114, the second assembly recess 115, the third assembly recess 214, and the fourth assembly recess 215 in a one-to-one correspondence (refer to FIG. 4). The following uses an example in which the first reinforcement member 40a is fastened to the first assembly recess 114 for description.

For example, a circumferential side surface of the first reinforcement member 40a may include a first surface 41, a second surface 42, a third surface 43, and a fourth surface 44. The first surface 41 of the first reinforcement member 40a may be disposed opposite to the third surface 43, and the second surface 42 of the first reinforcement member 40a may be disposed opposite to the fourth surface 44. The first reinforcement member 40a may be provided with a mounting hole 45. The mounting hole 45 may penetrate the second surface 42 and the fourth surface 44 of the first reinforcement member 40a. In some implementations, the first surface 41 may be connected to the second surface 42. Alternatively, the first surface 41 may be connected to the second surface 42 through a transition surface (for example, the transition surface may be an arc surface).

In other implementations, alternatively, shapes and sizes of a plurality of reinforcement members may not be completely the same.

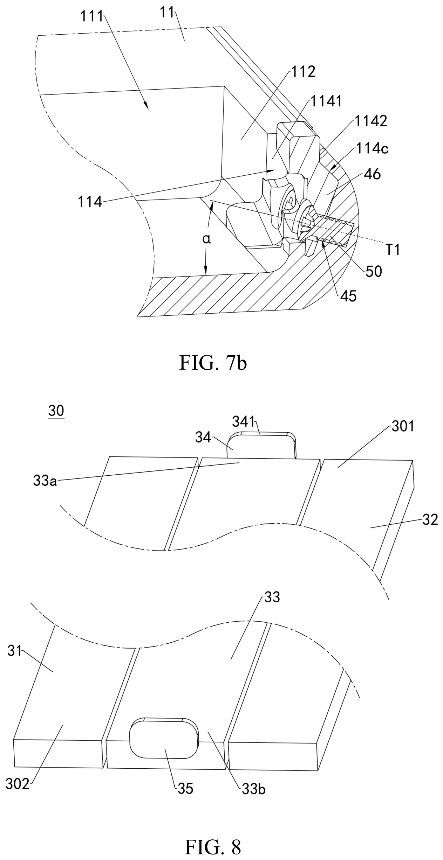

FIG. 7a is a diagram of a part of an assembly structure of the first reinforcement member 40a, a fastener 50, and the first middle frame 11 of the housing apparatus 100 shown in FIG. 3. FIG. 7b is a diagram of a structure of a part of a cross section according to an implementation in which the electronic device 1000 shown in FIG. 1a is cut along A-A.

As shown in FIG. 7a and FIG. 7b, the housing apparatus 100 may further include the fastener 50. The fastener 50 may sequentially penetrate the mounting hole 45 of the first reinforcement member 40a and the mounting recess 114a of the second recess wall 1142 to fasten the first reinforcement member 40a to the first assembly recess 114. A center line of the mounting hole 45 may coincide with a center line of the mounting recess 114a. In this way, a part of the fastener 50 may be embedded in the first reinforcement member 40a, and the other part of the fastener 50 may be embedded in the second recess wall 1142. This helps ensure reliability of a connection between the first reinforcement member 40a and the first middle frame 11. In this implementation, the fastener 50 may be a screw, a rivet, or another columnar fastener. A diameter of the fastener 50 may be less than or equal to 1.2 millimeters. For example, the diameter of the fastener 50 may be 0.3 millimeters, 0.42 millimeters, 0.6 millimeters, 1 millimeter, or the like. There may be two fasteners 50. In another implementation, there may be one or more than two fasteners 50. A quantity of the fasteners 50 is not specifically limited in this application.

For example, a first included angle α is formed between the center line T1 of the mounting hole 45 and a bottom wall that is of the first mounting groove 111 and that faces the screen 200. The first included angle α may be less than 90°. An opening of the mounting hole 45 may be disposed facing the screen 200. In this way, the mounting hole 45 may be disposed in an oblique manner relative to the bottom wall that is of the first mounting groove 111 and that faces the screen 200. Therefore, the fastener 50 can be mounted in the mounting hole 45 and the mounting recess 114a, so that fastening of the first reinforcement member 40a is more convenient, and assembly efficiency is improved.

For example, a part of the second surface 42 of the first reinforcement member 40a may further protrude in a direction toward the second recess wall 1142 to form a boss 46. The second recess wall 1142 may further be partially recessed inward to form accommodation space 114c for accommodating the boss 46 of the first reinforcement member 40a. In this way, the first reinforcement member 40a may be embedded in the second recess wall 1142 of the first assembly recess 114, and a contact area between the first reinforcement member 40a and the first middle frame 11 is large. This helps improve stability of the connection between the first reinforcement member 40a and the first middle frame 11.

In some implementations, the first reinforcement member 40a may be provided with two mounting holes 45 disposed side by side. The second recess wall 1142 may be provided with two mounting recesses 114a disposed side by side. There may alternatively be two fasteners 50. The two fasteners 50 may be respectively mounted in the two mounting holes 45 and the two mounting recesses 114a. In this case, the two fasteners 50 may be disposed side by side.

In another implementation, laser spot welding may be further performed at adjacent positions of the two fasteners 50 to fasten the two fasteners 50 to the first reinforcement member 40a, so that the first reinforcement member 40a and the two fasteners 50 may be fastened more reliably. This helps improve structural stability of the entire housing apparatus 100. Alternatively, the mounting recesses 114a may be filled with glue, so that the glue can fully fill gaps between the fasteners 50 and the mounting recesses 114a, to enhance reliability of a connection between the fasteners 50 and the second recess wall 1142.

In some other implementations, alternatively, the first reinforcement member 40a may not be provided with the mounting hole 45. Alternatively, the second recess wall 1142 may not be provided with the mounting recess 114a. In this case, the first reinforcement member 40a may be fastened to the second recess wall 1142 in a bonding manner. In other words, the fastener 50 may alternatively be a bonding adhesive.

In some other implementations, the center line of the mounting hole 45 may alternatively be parallel to the thickness direction of the electronic device 1000.

FIG. 8 is a diagram of a structure of the folding mechanism 30 of the housing apparatus 100 shown in FIG. 3.

As shown in FIG. 8, the folding mechanism 30 may include a first connection structure 31, a second connection structure 32, and a hinge structure 33. The first connection structure 31 and the second connection structure 32 may be approximately symmetric in structure. Both the first connection structure 31 and the second connection structure 32 may be connected to the hinge structure 33. Both the first connection structure 31 and the second connection structure 32 may move relative to the hinge structure 33.

For example, in a length extension direction of the folding mechanism 30, the folding mechanism 30 may include a first end portion 301 and a second end portion 302. A first stop block 34 may be disposed at the first end portion 301 of the folding mechanism 30. The first stop block 34 may include a first stop surface 341. When the electronic device 1000 is in the unfolded state, the first stop surface 341 may be disposed facing the screen 200 (refer to FIG. 2). In some implementations, when the electronic device 1000 is in the unfolded state, the first stop surface 341 may be disposed in parallel to the screen 200.

For example, in the length extension direction of the folding mechanism 30, the hinge structure 33 may include a first end 33a and a second end 33b that are disposed opposite to each other. The first stop block 34 may be located on a side that is of the first end 33a of the hinge structure 33 and that is away from the second end 33b and is fastened to the first end 33a. In the thickness direction of the electronic device 1000, the first stop block 34 may be exposed relative to the hinge structure 33. In some implementations, in the thickness direction of the electronic device 1000, alternatively, the first stop block 34 may not be exposed relative to the hinge structure 33.

For example, a second stop block 35 may be disposed at the second end portion 302 of the folding mechanism 30. Shapes and sizes of the first stop block 34 and the second stop block 35 may be approximately the same. The second stop block 35 may be located on a side that is of the second end 33b of the hinge structure 33 and that is away from the first end 33a and is fastened to the second end 33b. Disposition of the second stop block 35 is approximately the same as that of the first stop block 34. Details are not described herein again. In this case, the first end 33a of the hinge structure 33 and the first stop block 34 may form at least a part of the first end portion 301 of the folding mechanism 30. The second end 33b of the hinge structure 33 and the second stop block 35 may form at least a part of the second end portion 302.

In some implementations, alternatively, the shapes and sizes of the first stop block 34 and the second stop block 35 may not be completely the same. In another implementation, the folding mechanism 30 may not include the second stop block 35.

In some other implementations, the folding mechanism 30 may further include a first support plate (not shown in the figure) and a second support plate (not shown in the figure). The first support plate and the second support plate may be approximately symmetric in structure. The first support plate may be located above the first connection structure 31 and is fastened to the first connection piece. A projection of the first support plate in the thickness direction of the electronic device 1000 may overlap the first connection structure 31 and a part of the hinge structure 33. The second support plate may be located above the second connection structure 32 and is fastened to the second connection structure 32. A projection of the second support plate in the thickness direction of the electronic device 1000 may overlap the second connection structure 32 and a part of the hinge structure 33. In this way, in the thickness direction of the electronic device 1000, the first support plate and the second support plate may cover an upper surface of the first connection structure 31, an upper surface of the second connection structure 32, and uneven positions on an upper surface of the hinge structure 33, so that when the electronic device 1000 is in the unfolded state, a flat support environment can be provided for the screen 200.

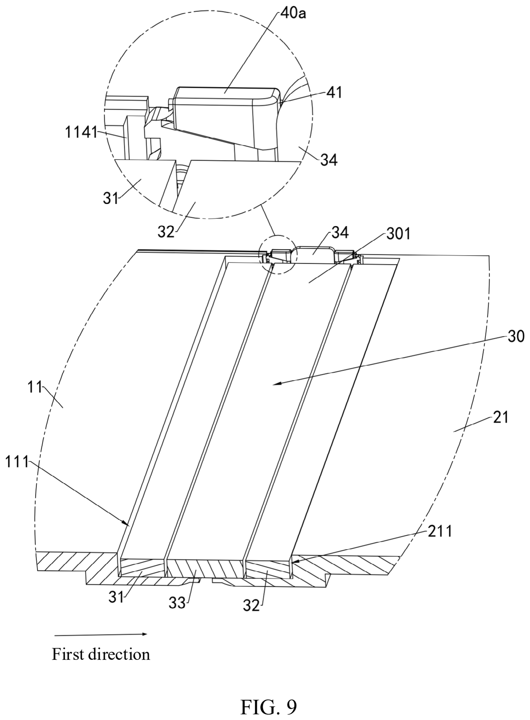

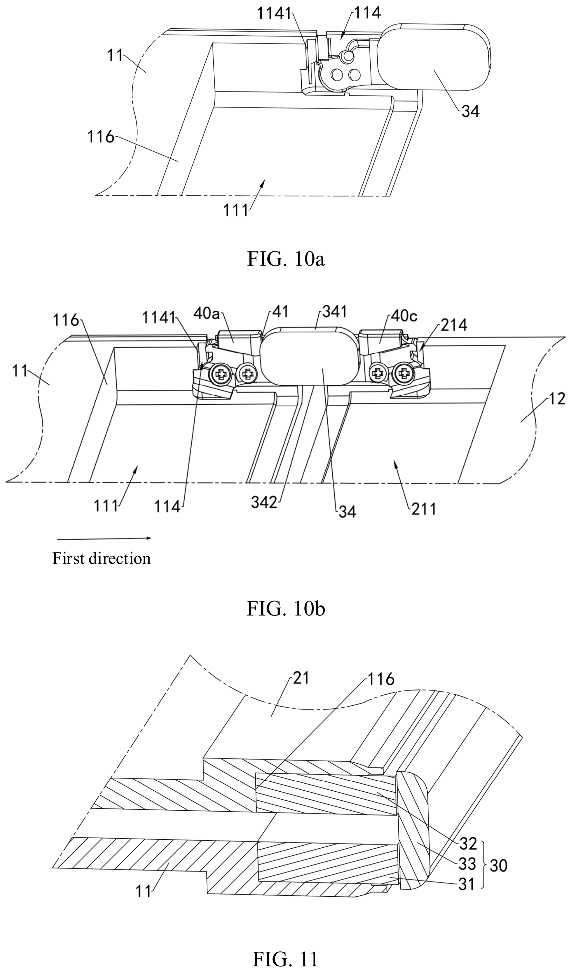

FIG. 9 is a diagram of a structure of a part of a cross section according to an implementation of the electronic device 1000 shown in FIG. 1a that is cut along B-B. FIG. 10a is a diagram of a part of assembly of the first middle frame 11 and the folding mechanism 30 shown in FIG. 4. FIG. 10b is a diagram of a part of an assembly structure of the first middle frame 11, the second middle frame 21, and the folding mechanism 30 shown in FIG. 4. In FIG. 10a and FIG. 10b, the first connection structure 31, the second connection structure 32, and the hinge structure 33 in the folding mechanism 30 are hidden, and only the first stop block 34 of the folding mechanism 30 is reserved.

As shown in FIG. 9 and FIG. 10b, at least a part of the first connection structure 31 of the folding mechanism 30 may be located in the first mounting groove 111 and is connected to the first middle frame 11. At least a part of the second connection structure 32 of the folding mechanism 30 may be located in the second mounting groove 211 and is connected to the second middle frame 21. For example, a part of the hinge structure 33 of the folding mechanism 30 may be located in the first mounting groove 111, and a part of the hinge structure 33 may be located in the second mounting groove 211.

For example, a part of the first stop block 34 of the folding mechanism 30 may be located in the first assembly recess 114, and a part of the first stop block 34 may be located in the third assembly recess 214. A part of the second stop block 35 of the folding mechanism 30 may be located in the second assembly recess 115, and a part of the second stop block 35 may be located in the fourth assembly recess 215 (refer to FIG. 3). In other words, the first assembly recess 114 and the third assembly recess 214 may be configured to avoid at least a part of the first stop block 34 in the folding mechanism 30. The second assembly recess 115 and the fourth assembly recess 215 may be configured to avoid at least a part of the second stop block 35 of the folding mechanism 30. In another implementation, alternatively, the first stop block 34 may not be located in the first assembly recess 114 and/or the third assembly recess 214.

When the electronic device 1000 is in the unfolded state, the first middle frame 11 and the second middle frame 21 may be unfolded into a flat state relative to each other. The first connection structure 31 and the second connection structure 32 of the folding mechanism 30 may be unfolded into a flat state relative to each other. A direction from the first middle frame 11 to the second middle frame 21 may be a first direction. The first direction may be perpendicular to the length extension direction of the folding mechanism 30 and the thickness direction of the electronic device 1000. In this case, the first connection structure 31 and the second connection structure 32 may be respectively located on two sides that are of the hinge structure 33 and that are opposite to each other. The first reinforcement member 40a may be located between the first recess wall 1141 of the first assembly recess 114 and the first stop block 34 of the folding mechanism 30 (that is, the first reinforcement member 40a may be located between the first groove side wall 116 of the first mounting groove 111 and the first stop block 34). The third surface 43 of the first reinforcement member 40a may be in contact with the first recess wall 1141 of the first assembly recess 114. The first surface 41 of the first reinforcement member 40a and the first stop block 34 of the folding mechanism 30 may be spaced apart. A distance between the first surface 41 of the first reinforcement member 40a and the first stop block 34 of the folding mechanism 30 in the first direction may be less than or equal to three millimeters. In this case, a distance between the first reinforcement member 40a and the first stop block 34 of the folding mechanism 30 is short.

In some implementations, when the electronic device 1000 is in the unfolded state, in the first direction, a width of the first stop block 34 may be less than a width of the hinge structure 33.

In some other implementations, alternatively, the first reinforcement member 40a may further be in contact with the first stop block 34 of the folding mechanism 30.

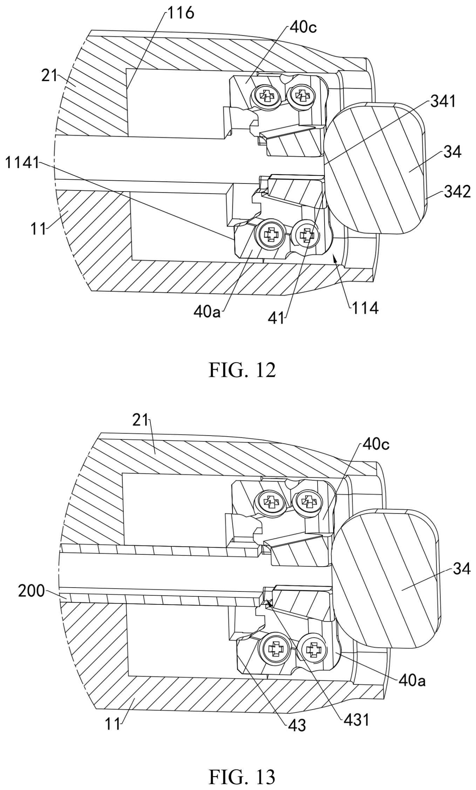

FIG. 11 is a diagram of a structure of a part of a cross section according to an implementation in which the electronic device 1000 shown in FIG. 1b is cut along C-C. FIG. 12 is a diagram of a structure of a part of a cross section according to an implementation in which the electronic device 1000 shown in FIG. 1b is cut along D-D.

As shown in FIG. 11 and FIG. 12, when the electronic device 1000 is in the folded state, the first middle frame 11 and the second middle frame 21 may be folded relative to each other. The first connection structure 31 and the second connection structure 32 of the folding mechanism 30 may be folded relative to each other. In this case, space between the first middle frame 11 and the second middle frame 21 and space between the first connection structure 31 and the second connection structure 32 may be used to accommodate the screen 200.

For example, both the first connection structure 31 and the second connection structure 32 may be located on a same side of the hinge structure 33. The first reinforcement member 40a located in the first assembly recess 114 may be located between the first recess wall 1141 of the first assembly recess 114 and the first stop block 34 of the folding mechanism 30 (that is, the first reinforcement member 40a may be located between the first groove side wall 116 of the first mounting groove 111 and the first stop block 34). The third surface 43 of the first reinforcement member 40a may be in contact with the first recess wall 1141 of the first assembly recess 114. The first surface 41 of the first reinforcement member 40a may be in contact with the first stop surface 341 of the first stop block 34.

When the electronic device 1000 switches from the unfolded state to the folded state, the second middle frame 21 may be folded relative to the first middle frame 11 until the first surface 41 of the first reinforcement member 40a abuts against the first stop surface 341 of the first stop block 34. In other words, the first stop surface 341 of the first stop block 34 may be used to stop the electronic device 1000 in a folding process of the electronic device 1000, to avoid damage to the screen 200 caused by excessive folding of the first middle frame 11 and the second middle frame 21.

It may be understood that in this implementation, the first middle frame 11 has the first assembly recess 114 for assembling the first reinforcement member 40a. The first reinforcement member 40a is disposed in the first assembly recess 114, so that the first reinforcement member 40a may be located between the first recess wall 1141 of the first assembly recess 114 and the first stop block 34 of the folding mechanism 30. Yield strength of the first reinforcement member 40a may be greater than yield strength of the first middle frame 11, and/or micro Vickers hardness of the first reinforcement member 40a may be greater than micro Vickers hardness of the first middle frame 11. In this way, when the electronic device 1000 is dropped, especially when the electronic device 1000 is dropped in the folded state, the first reinforcement member 40a may directly bear an impact force from the first stop block 34 of the hinge structure 33. This can effectively avoid a problem of local collapse and deformation of the first middle frame 11 caused by strong collision between the first stop block 34 of the hinge structure 33 and an adjacent part of the first middle frame 11 (that is, the first recess wall 1141 of the first assembly recess 114 in this implementation) due to a large impact force, and this helps prolong a service life of the electronic device 1000.

Second, upon comparison, in a conventional electronic device 1000, the first middle frame 11 is manufactured by using a high-strength material, to improve yield strength and/or micro Vickers hardness of the first middle frame 11. However, manufacturing the entire first middle frame 11 by using the high-strength material greatly increases a weight and manufacturing costs of the first middle frame 11. In this implementation, only the first reinforcement member 40a is disposed between the first recess wall 1141 of the first assembly recess 114 and the first stop block 34 of the folding mechanism 30. In addition, the yield strength of the first reinforcement member 40a is greater than the yield strength of the first middle frame 11, and/or the micro Vickers hardness of the first reinforcement member 40a is greater than the micro Vickers hardness of the first middle frame 11. Therefore, there is no need to replace the entire material of the first middle frame 11 with the high-strength material, so that an overall weight of the first middle frame 11 is light, thereby facilitating implementation of a lightweight design of the electronic device 1000, and the manufacturing costs of the first middle frame 11 are low, thereby facilitating reduction of the manufacturing costs of the entire electronic device 1000.

In addition, in this implementation, the yield strength of the first reinforcement member 40a may further be equal to yield strength of the first stop block 34 of the folding mechanism 30, and/or the micro Vickers hardness of the first reinforcement member 40a may alternatively be equal to micro Vickers hardness of the first stop block 34. In this way, the yield strength of the first reinforcement member 40a is high, so that the first reinforcement member 40a can better bear an impact force from the first stop block 34 of the folding mechanism 30, and the first reinforcement member 40a has a better impact resistance capability. In addition, the yield strength of the first reinforcement member 40a is equal to the yield strength of the first stop block 34 of the folding mechanism 30, so that the first reinforcement member 40a is not easily deformed even if the first reinforcement member 40a is impacted by the first stop block 34 of the folding mechanism 30. This helps prolong a service life of the first reinforcement member 40a. In addition, a case in which after the first stop block 34 of the folding mechanism 30 collides with the first reinforcement member 40a, the first stop block 34 undergoes local collapse and deformation because the yield strength of the first reinforcement member 40a is greater than the yield strength of the first stop block 34 of the folding mechanism 30, and/or the micro Vickers hardness of the reinforcement member 40a is greater than the micro Vickers hardness of the first stop block 34 does not occur. This helps prolong a service life of the folding mechanism 30, thereby helping prolong the service life of the entire electronic device 1000.

In addition, the housing apparatus 100 in this implementation may further include the fastener 50. The first reinforcement member 40a may further be provided with the mounting hole 45. The second recess wall 1142 of the first assembly recess 114 may further be provided with the mounting recess 114a. The fastener 50 may sequentially penetrate the mounting hole 45 of the first reinforcement member 40a and the mounting recess 114a of the second recess wall 1142 to fasten the first reinforcement member 40a to the first assembly recess 114. In this way, a part of the fastener 50 may be embedded in the first reinforcement member 40a, and the other part of the fastener 50 may be embedded in the first middle frame 11, so that reliability of a connection between the first reinforcement member 40a and the first middle frame 11 is improved. In addition, the part of the fastener 50 is embedded in the first middle frame 11, so that when the first reinforcement member 40a bears an impact force from the folding mechanism 30, a part of impact load may be further transferred to the first middle frame 11 through the fastener 50, and in this way, the first middle frame 11 may further share the part of the impact load. This helps improve an impact resistance capability of the first reinforcement member 40a.

In addition, when the electronic device 1000 is in the unfolded state, a distance between the first reinforcement member 40a and the first stop block 34 of the folding mechanism 30 in the first direction may be less than or equal to three millimeters, that is, the first reinforcement member 40a may be disposed adjacent to the first stop block 34 of the folding mechanism 30, and the first reinforcement member 40a has better impact resistance effect. This helps prolong the service life of the electronic device 1000.

In some implementations, refer to FIG. 10b and FIG. 12 together, the first stop block 34 may further include a second stop surface 342. When the electronic device 1000 is in the folded state, the second stop surface 342 may be disposed away from the first reinforcement member 40a. When the electronic device 1000 is switched from the folded state to the unfolded state, the second middle frame 21 may be unfolded relative to the first middle frame 11 until the first stop block 34 abuts against a part of a surface of the first middle frame 11, and the first stop block 34 abuts against a part of a surface of the second middle frame 21. In other words, the second stop surface 342 of the first stop block 34 may be used to stop the electronic device 1000 in an unfolding process of the electronic device 1000, to avoid damage to the screen 200 caused by excessive unfolding of the first middle frame 11 and the second middle frame 21.

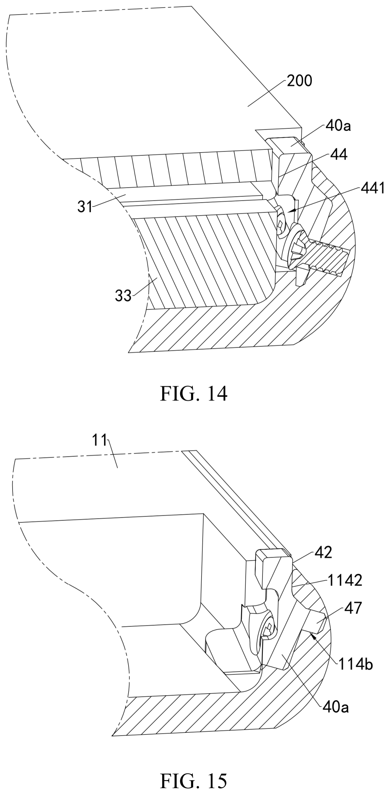

FIG. 13 is a diagram of a structure of a part of a cross section according to an implementation in which the electronic device 1000 shown in FIG. 1b is cut along D-D. FIG. 14 is a diagram of a structure of a part of a cross section according to an implementation in which the electronic device 1000 shown in FIG. 1a is cut along A-A.

As shown in FIG. 13 and FIG. 14, partial edge cutting or partial recessing may be performed on the circumferential side surface of the first reinforcement member 40a to form avoidance space. For example, a part that is of the third surface 43 and that is close to the screen 200 may be partially recessed to form first avoidance space 431. In this way, the first avoidance space 431 may be used to avoid the screen 200, to prevent the screen 200 from being uneven and user experience from being affected due to a case in which the first reinforcement member 40a pushes up the screen 200.

For example, a part that is of the fourth surface 44 of the first reinforcement member 40a and that is close to the first connection structure 31 and/or the hinge structure 33 of the folding mechanism 30 may further be partially recessed to form second avoidance space 441. In this way, the second avoidance space 441 may be used to avoid the first connection structure 31 and/or the hinge structure 33 of the folding mechanism 30, so that an overall structure of the electronic device 1000 is more compact. It should be understood that a shape of the first reinforcement member 40a in this implementation may be adapted to a shape of another component adjacent to the first reinforcement member 40a, that is, the first reinforcement member 40a may have a plurality of shapes. This is not strictly limited in this application.

FIG. 15 is a diagram of a structure of a part of a cross section according to an implementation in which the electronic device shown in FIG. 1a is cut along E-E.

As shown in FIG. 15, a limiting protrusion 47 may be further disposed on the second surface 42 of the first reinforcement member 40a (FIG. 6 also shows the limiting protrusion 47 from another angle of view). The limiting protrusion 47 and the mounting hole 45 may be spaced apart. The second recess wall 1142 of the first assembly recess 114 may further be provided with a matching recess 114b. A shape of the limiting protrusion 47 may be adapted to a shape of the matching recess 114b. The limiting protrusion 47 may be embedded in the matching recess 114b. The limiting protrusion 47 may be approximately columnar. In this way, the limiting protrusion 47 may cooperate with the fastener 50, to enhance stability of a connection between the first reinforcement member 40a and the first assembly recess 114. In addition, when the first reinforcement member 40a is subject to the impact force from the folding mechanism 30, the limiting protrusion 47 may also share a part of the impact load, so that the first reinforcement member 40a can bear a larger impact force. This helps improve the impact resistance capability of the first reinforcement member 40a.

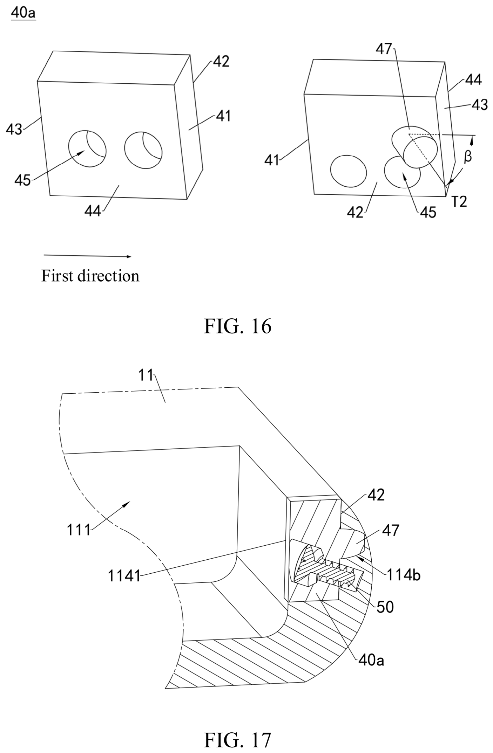

FIG. 16 is a diagram of a structure of the first reinforcement member 40a shown in FIG. 6 according to another implementation. FIG. 17 is a diagram of the structure shown in FIG. 7b according to another implementation.

As shown in FIG. 16 and FIG. 17, a structure of the first reinforcement member 40a in this implementation is roughly the same as the structure of the first reinforcement member 40a shown in FIG. 6, and a same part is not described again. The following mainly describes differences between the two implementations. In this implementation, a length extension direction of the limiting protrusion 47 of the first reinforcement member 40a may intersect the first direction. An included angle between the length extension direction of the limiting protrusion 47 and the first direction may be a second included angle β. The second included angle β may be less than 90°. An opening of the second included angle β may face the first recess wall 1141 of the first assembly recess 114, that is, the opening of the second included angle β may face the third surface 43 of the first reinforcement member 40a.

It may be understood that in this implementation, the limiting protrusion 47 is disposed on a surface (that is, the second surface 42 of the first reinforcement member 40a in this implementation) that is of the first reinforcement member 40a and that faces the first assembly recess 114. The second included angle β that is less than 90° may be formed between the length extension direction of the limiting protrusion 47 and the first direction, and the opening of the second included angle β may face the first recess wall 1141 of the first assembly recess 114, that is, the opening of the second included angle β may face the third surface 43 of the first reinforcement member 40a. In this way, when the first reinforcement member 40a is subject to an impact force from the folding mechanism 30, the limiting protrusion 47 may also share a part of the impact load, so that the first reinforcement member 40a can bear a larger impact force. This helps improve the impact resistance capability of the first reinforcement member 40a.

In some implementations, glue may be further dispensed in the matching recess 114b of the first assembly recess 114, so that the limiting protrusion 47 of the first reinforcement member 40a may be more reliably embedded in the matching recess 114b of the first assembly recess 114. This helps improve reliability of the connection between the first reinforcement member 40a and the first middle frame 11.

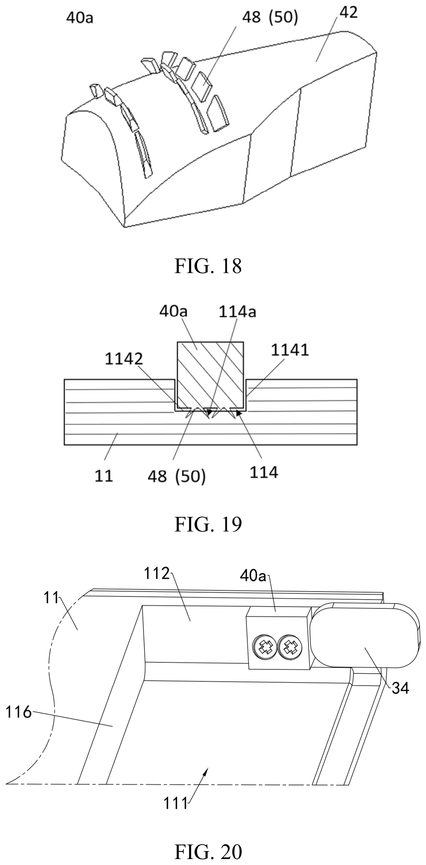

FIG. 18 is a diagram of a structure of the first reinforcement member 40a shown in FIG. 6 at a different angle of view according to another implementation. FIG. 19 is a diagram of the structure shown in FIG. 7b at another angle of view according to still another implementation.

As shown in FIG. 18 and FIG. 19, a structure of the first reinforcement member 40a in this implementation is roughly the same as the structure of the first reinforcement member 40a shown in FIG. 6, and a same part is not described again. The following mainly describes differences between the two implementations. In this implementation, alternatively, the first reinforcement member 40a may not be provided with the mounting hole. At least one connection protrusion 48 may be further disposed on the second surface 42. A shape of the mounting recess 114a of the first assembly recess 114 may be adapted to a shape of the connection protrusion 48. A quantity of mounting recesses 114a may be equal to a quantity of connection protrusions 48. In this case, the first reinforcement member 40a may be embedded in and fastened to the second recess wall 1142 of the first assembly recess 114 through cooperation between the connection protrusion 48 and the mounting recess 114a. The connection protrusion 48 may form the fastener 50 of the housing apparatus 100. For example, length extension directions of a plurality of connection protrusions 48 may intersect.

It may be understood that in this implementation, the connection protrusion 48 is formed on a surface (that is, the second surface 42 of the first reinforcement member 40a in this implementation) that is of the first reinforcement member 40a and that faces the second recess wall 1142 of the first assembly recess 114, and the first reinforcement member 40a is fastened to the second recess wall 1142 through cooperation between the connection protrusion 48 and the mounting recess 114a, to replace a fastening solution in which an additional fastener 50 (for example, a screw) is disposed to fasten the first reinforcement member 40a to the second recess wall 1142, so that no additional fastener needs to be disposed on the housing apparatus 100. This helps reduce overall manufacturing costs of the electronic device 1000. Second, the connection protrusion 48 in this implementation is directly formed on the surface of the first reinforcement member 40a, the connection protrusion 48 and the first reinforcement member 40a may be integrally processed, and a manufacturing process is simpler. In addition, volumes of the connection protrusion 48 and the first reinforcement member 40a may be smaller, so that the connection protrusion 48 and the first reinforcement member 40a can be better adapted to the electronic device 1000 in which the first middle frame 11 has a thin wall, and the connection protrusion 48 and the first reinforcement member 40a are more widely used.

FIG. 20 is a diagram of a part of the structure shown in FIG. 10a according to another implementation.

As shown in FIG. 20, a structure of the electronic device 1000 in this implementation is approximately the same as the structure of the electronic device 1000 shown in FIG. 10a, and a same part is not described again. The following describes differences between the two implementations. In this implementation, alternatively, the first groove end wall 112 of the first mounting groove 111 of the first middle frame 11 may not be provided with the first assembly recess. The first reinforcement member 40a may alternatively be directly fastened to the first groove end wall 112 of the first mounting groove 111. In this case, the first reinforcement member 40a may be located between the first groove side wall 116 of the first mounting groove 111 and the first stop block 34.

It should be noted that when no conflict occurs, features in implementations in this application may be mutually combined, and any combination of features in different implementations also falls within the protection scope of this application. In other words, the plurality of implementations described above may be alternatively combined according to an actual requirement.

It should be noted that all of the foregoing accompanying drawings are example drawings of this application, and do not represent actual sizes of products. In addition, a size proportion relationship between components in the accompanying drawings is not intended to limit an actual product in this application.

The foregoing descriptions are merely some implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device (1000), comprising a screen (200), a first middle frame (11), a folding mechanism (30), a second middle frame (21), and a first reinforcement member (40a), wherein the screen (200) is mounted on the first middle frame (11) and the second middle frame (21), the folding mechanism (30) connects the first middle frame (11) and the second middle frame (21), and the first middle frame (11) and the second middle frame (21) are unfolded or folded relative to each other, to drive the screen (200) to be unfolded or folded;
a side portion that is of the first middle frame (11) and that is close to the second middle frame (21) is provided with a first mounting groove (111), the first mounting groove (111) comprises a first groove end wall (112), a second groove end wall (113), and a first groove side wall (116), the first groove end wall (112) and the second groove end wall (113) are disposed opposite to each other, the first groove side wall (116) is connected between the first groove end wall (112) and the second groove end wall (113), the first reinforcement member (40a) is located on a side that is of the first groove end wall (112) and that faces the second groove end wall (113) and is fastened to the first groove end wall (112), a part of the folding mechanism (30) is located in the first mounting groove (111), a first end portion (301) and a second end portion (302) that are disposed opposite to each other are comprised in a length extension direction of the folding mechanism (30), and a first stop block (34) is disposed at the first end portion (301);
the electronic device (1000) has an unfolded state and a folded state; and when the electronic device (1000) is in the unfolded state, the first middle frame (11) and the second middle frame (21) are unfolded into a flat state relative to each other, the first groove side wall (116) of the first mounting groove (111) faces the second middle frame (21), and the first reinforcement member (40a) is located between the first groove side wall (116) and the first stop block (34) of the folding mechanism (30);
when the electronic device (1000) is in the folded state, the first middle frame (11) and the second middle frame (21) are folded relative to each other, and the first reinforcement member (40a) is located between the first groove side wall (116) and the first stop block (34) and abuts against the first stop block (34); and
yield strength of the first reinforcement member (40a) is greater than yield strength of the first middle frame (11), and/or micro Vickers hardness of the first reinforcement member (40a) is greater than micro Vickers hardness of the first middle frame (11).

2. The electronic device (1000) according to claim 1, wherein the first groove end wall (112) is provided with a first assembly recess (114), and the first reinforcement member (40a) is fastened to the first assembly recess (114) and is at least partially located in the first assembly recess (114);
when the electronic device (1000) is in the unfolded state, the first middle frame (11) and the second middle frame (21) are unfolded into the flat state relative to each other, a first recess wall (1141) of the first assembly recess (114) faces the second middle frame (21), and the first reinforcement member (40a) is located between the first recess wall (1141) of the first assembly recess (114) and the first stop block (34) of the folding mechanism (30); and
when the electronic device (1000) is in the folded state, the first middle frame (11) and the second middle frame (21) are folded relative to each other, and the first reinforcement member (40a) is located between the first recess wall (1141) and the first stop block (34) and abuts against the first stop block (34).

3. The electronic device (1000) according to claim 2, wherein the first reinforcement member (40a) comprises a first surface (41) disposed away from the first groove side wall (116), the first stop block (34) comprises a first stop surface (341), and when the electronic device (1000) is in the unfolded state, the first stop surface (341) is disposed facing the screen (200); and
when the electronic device (1000) is switched from the unfolded state to the folded state, the first middle frame (11) is folded relative to the second middle frame (21) until the first surface (41) of the first reinforcement member (40a) abuts against the first stop surface (341) of the first stop block (34).

4. The electronic device (1000) according to claim 2 or 3, wherein when the electronic device (1000) is in the unfolded state, a direction from the first middle frame (11) to the second middle frame (21) is a first direction, and in the first direction, a distance between the first reinforcement member (40a) and the first stop block (34) of the folding mechanism (30) is less than or equal to three millimeters.

5. The electronic device (1000) according to any one of claims 2 to 4, wherein the first assembly recess (114) further comprises a second recess wall (1142), the second recess wall (1142) faces the first mounting groove (111), the electronic device (1000) further comprises a fastener (50), and the fastener (50) fastens the first reinforcement member (40a) to the second recess wall (1142).

6. The electronic device (1000) according to claim 5, wherein the first reinforcement member (40a) is provided with a mounting hole (45), the second recess wall (1142) is provided with a mounting recess (114a), the mounting hole (45) communicates with the mounting recess (114a), a part of the fastener (50) is located in the mounting hole (45), and the other part of the fastener (50) is located in the mounting recess (114a).

7. The electronic device (1000) according to claim 6, wherein a first included angle (α) is formed between a center line of the mounting hole (45) and a bottom wall of the first mounting groove (111), the first included angle (α) is less than 90°, and an opening of the mounting hole (45) faces the screen (200).

8. The electronic device (1000) according to claim 6 or 7, wherein a limiting protrusion (47) is disposed on the first reinforcement member (40a), the limiting protrusion (47) and the mounting hole (45) are spaced apart, the second recess wall (1142) is further provided with a matching recess (114b), the matching recess (114b) and the mounting recess (114a) are spaced apart, and the limiting protrusion (47) is embedded in the matching recess (114b).

9. The electronic device (1000) according to claim 8, wherein a second included angle (β) is formed between a center line of the limiting protrusion (47) and the first direction, the second included angle (β) is less than 90°, an opening of the second included angle (β) faces the first recess wall (1141), and the first direction is the direction from the first middle frame (11) to the second middle frame (21) when the electronic device (1000) is in the unfolded state.

10. The electronic device (1000) according to any one of claims 2 to 4, wherein the first assembly recess (114) further comprises a second recess wall (1142), the second recess wall (1142) faces the first mounting groove (111), a connection protrusion (48) is disposed on a surface that is of the first reinforcement member (40a) and that faces the second recess wall (1142), the second recess wall (1142) is provided with a mounting recess (114a), and the connection protrusion (48) is embedded in the mounting recess (114a) to fasten the first reinforcement member (40a) to the second recess wall (1142).

11. The electronic device (1000) according to any one of claims 1 to 10, wherein the folding mechanism (30) comprises a first connection structure (31), a second connection structure (32), and a hinge structure (33), the hinge structure (33) connects the first connection structure (31) and the second connection structure (32), at least a part of the first connection structure (31) is located in the first mounting groove (111) and is connected to the first middle frame (11), a side portion that is of the second middle frame (21) and that is close to the first middle frame (11) is provided with a second mounting groove (211), and at least a part of the second connection structure (32) is located in the second mounting groove (211) and is connected to the second middle frame (21); and
in the length extension direction of the folding mechanism (30), the hinge structure (33) comprises a first end (33a) and a second end (33b) that are disposed opposite to each other, and the first stop block (34) is located on a side that is of the first end (33a) and that is away from the second end (33b) and is fastened to the first end (33a).

12. The electronic device (1000) according to claim 11, wherein when the electronic device (1000) is in the unfolded state, the direction from the first middle frame (11) to the second middle frame (21) is the first direction, and in the first direction, a width of the first stop block (34) is less than a width of the hinge structure (33).

13. The electronic device (1000) according to any one of claims 1 to 12, wherein a difference between the yield strength of the first reinforcement member (40a) and the yield strength of the first middle frame (11) is greater than 50 MPa, and/or a difference between the micro Vickers hardness of the first reinforcement member (40a) and the micro Vickers hardness of the first middle frame (11) is greater than 30 HV.

14. The electronic device (1000) according to any one of claims 1 to 13, wherein the yield strength of the first reinforcement member (40a) is less than or equal to yield strength of the first stop block (34) of the folding mechanism (30), and/or the micro Vickers hardness of the first reinforcement member (40a) is less than or equal to micro Vickers hardness of the first stop block (34) of the folding mechanism (30).

15. The electronic device (1000) according to any one of claims 1 to 14, wherein a material of the first reinforcement member (40a) is a titanium alloy material, an iron-based material, an aluminum-based material, a copper-based material, or a nickel-based material.

16. The electronic device (1000) according to any one of claims 1 to 15, wherein the first middle frame (11) comprises a main plate (11a), a first extension plate (11b), a second extension plate (11c), and a third extension plate (11d); and
the first extension plate (11b) and the second extension plate (11c) are connected to a same side of the main plate (11a) and are respectively located at two ends of the main plate (11a), the third extension plate (11d) is connected between the first extension plate (11b) and the second extension plate (11c), the third extension plate (11d) is further connected to the main plate (11a), there is a height difference between the third extension plate (11d) and the main plate (11a) in a thickness direction of the first middle frame (11), the main plate (11a), the first extension plate (11b), the second extension plate (11c), and the third extension plate (11d) enclose the first mounting groove (111), a surface that is of the first extension plate (11b) and that faces the second extension plate (11c) forms the first groove end wall (112), and a surface that is of the main plate (11a) and that faces the first extension plate (11b) forms the first groove side wall (116).

17. A housing apparatus (100), comprising a first middle frame (11), a folding mechanism (30), a second middle frame (21), and a first reinforcement member (40a), wherein the folding mechanism (30) connects the first middle frame (11) and the second middle frame (21), and the first middle frame (11) and the second middle frame (21) are unfolded or folded relative to each other, so that the housing apparatus (100) is unfolded or folded;
a side portion that is of the first middle frame (11) and that is close to the second middle frame (21) is provided with a first mounting groove (111), the first mounting groove (111) comprises a first groove end wall (112), a second groove end wall (113), and a first groove side wall (116), the first groove end wall (112) and the second groove end wall (113) are disposed opposite to each other, the first groove side wall (116) is connected between the first groove end wall (112) and the second groove end wall (113), the first reinforcement member (40a) is located on a side that is of the first groove end wall (112) and that faces the second groove end wall (113) and is fastened to the first groove end wall (112), a part of the folding mechanism (30) is located in the first mounting groove (111), a first end portion (301) and a second end portion (302) that are disposed opposite to each other are comprised in a length extension direction of the folding mechanism (30), and a first stop block (34) is disposed at the first end portion (301);
the housing apparatus (100) has an unfolded state and a folded state; when the housing apparatus (100) is in the unfolded state, the first middle frame (11) and the second middle frame (21) are unfolded into a flat state relative to each other, the first groove side wall (116) of the first mounting groove (111) faces the second middle frame (21), and the first reinforcement member (40a) is located between the first groove side wall (116) and the first stop block (34) of the folding mechanism (30);
when the housing apparatus (100) is in the folded state, the first middle frame (11) and the second middle frame (21) are folded relative to each other, and the first reinforcement member (40a) is located between the first groove side wall (116) and the first stop block (34) and abuts against the first stop block (34); and
yield strength of the first reinforcement member (40a) is greater than yield strength of the first middle frame (11), and/or micro Vickers hardness of the first reinforcement member (40a) is greater than micro Vickers hardness of the first middle frame (11).

18. The housing apparatus (100) according to claim 17, wherein the first groove end wall (112) is provided with a first assembly recess (114), and the first reinforcement member (40a) is fastened to the first assembly recess (114) and at least partially located in the first assembly recess (114);
when the housing apparatus (100) is in the unfolded state, the first middle frame (11) and the second middle frame (21) are unfolded into the flat state relative to each other, a first recess wall (1141) of the first assembly recess (114) faces the second middle frame (21), and the first reinforcement member (40a) is located between the first recess wall (1141) of the first assembly recess (114) and the first stop block (34) of the folding mechanism (30); and
when the housing apparatus (100) is in the folded state, the first middle frame (11) and the second middle frame (21) are folded relative to each other, and the first reinforcement member (40a) is located between the first recess wall (1141) and the first stop block (34) and abuts against the first stop block (34).

19. The housing apparatus (100) according to claim 18, wherein a side that is of the housing apparatus (100) and that is used to mount a screen (200) is a mounting side (100a) of the housing apparatus (100); the first reinforcement member (40a) comprises a first surface (41) disposed away from the first recess wall (1141); the first stop block (34) comprises a first stop surface (341); when the housing apparatus (100) is in the unfolded state, the first stop surface (341) is disposed facing the mounting side (100a); and when the housing apparatus (100) is switched from the unfolded state to the folded state, the first middle frame (11) is folded relative to the second middle frame (21) until the first surface (41) of the first reinforcement member (40a) abuts against the first stop surface (341) of the first stop block (34).

20. The housing apparatus (100) according to claim 18 or 19, wherein when the housing apparatus (100) is in the unfolded state, a direction from the first middle frame (11) to the second middle frame (21) is a first direction, and in the first direction, a distance between the first reinforcement member (40a) and the first stop block (34) of the folding mechanism (30) is less than or equal to three millimeters.

21. The housing apparatus (100) according to any one of claims 18 to 20, wherein the first assembly recess (114) further comprises a second recess wall (1142), the second recess wall (1142) faces the first mounting groove (111), the housing apparatus (100) further comprises a fastener (50), and the fastener (50) fastens the first reinforcement member (40a) to the second recess wall (1142).

22. The housing apparatus (100) according to claim 21, wherein the first reinforcement member (40a) is provided with a mounting hole (45), the second recess wall (1142) is provided with a mounting recess (114a), the mounting hole (45) communicates with the mounting recess (114a), a part of the fastener (50) is located in the mounting hole (45), and the other part of the fastener (50) is located in the mounting recess (114a).

23. The housing apparatus (100) according to claim 22, wherein a first included angle (α) is formed between a center line of the mounting hole (45) and a bottom wall of the first mounting groove (111), the first included angle (α) is less than 90°, and an opening of the mounting hole (45) faces the mounting side (100a).

24. The housing apparatus (100) according to any one of claims 18 to 23, wherein a difference between the yield strength of the first reinforcement member (40a) and the yield strength of the first middle frame (11) is greater than 50 MPa, and/or a difference between the micro Vickers hardness of the first reinforcement member (40a) and the micro Vickers hardness of the first middle frame (11) is greater than 30 HV.

25. The housing apparatus (100) according to any one of claims 18 to 23, wherein the yield strength of the first reinforcement member (40a) is less than or equal to yield strength of the first stop block (34) of the folding mechanism (30), and/or the micro Vickers hardness of the first reinforcement member (40a) is less than or equal to micro Vickers hardness of the first stop block (34) of the folding mechanism (30).

26. The housing apparatus (100) according to any one of claims 18 to 25, wherein a material of the first reinforcement member (40a) is a titanium alloy material, an iron-based material, an aluminum-based material, a copper-based material, or a nickel-based material.
